# EUROPEAN PATENT APPLICATION

(11) **EP 0 955 720 A2**
(43) Date of publication of application: **10.11.1999**
(21) Application number: 99303545.0
(22) Date of filing: 06.05.1999
(51) Int. Cl.: H02M 7/48, H01L 41/107

(54) **Piezoelectric transformers**

(30) Priority: 08.05.1998 GB 9809948
(71) Applicant: Kigass Electronics Ltd., Fareham, Hampshire PO15 5SH (GB)
(72) Inventor: Chuter, Barry Ian, Totton SO40 8XL (GB)
(74) Representative: Pratt, Richard Wilson

(57) **Abstract**

A circuit (2 to 4) drives a piezo-electric transformer (1) to resonate over a predetermined range of operating conditions over which it has a range of resonant frequencies. The circuit comprises drive means (2 to 4) arranged to produce independently of the transformer (1) a signal having frequencies spanning the range of resonant frequencies for application to the transformer.

## Description

The present invention relates to circuits for driving piezoelectric transformers, to piezoelectric transformers and to apparatus, such as gas ignition circuits, which use such transformers.

Piezoelectric transformers are known from for example "Application Notes" of Philips Magnetic Products entitled "Piezoelectric Transformers. Those Application Notes state that the principle of operation of a piezoelectric transformer "is that deformations in one region of a piezo-electric body, produced by an applied voltage, can be transformed into a deformation and hence a second voltage over another region of the same body." The body must be in mechanical resonance and the applied voltage is an AC waveform, at the resonant frequency, produced by an oscillator circuit. The waveform is preferably a sinusoid but in practice may be a square wave because a square wave is easier to generate. The Application Notes make clear that incorrect mounting affects, adversely, the performance of the transformer. Such transformers are very sensitive to electrical load variations which adversely affect the resonant frequency. It has also been found that resonance is affected by temperature variations.

The application notes recommend the use of feedback from the piezoelectric body to the oscillator circuit to ensure that the oscillator frequency tracks the resonant frequency of the body. This however complicates the circuit increasing cost and involves the usual problems of designing feedback circuits which are stable over the desired operating range.

Some potential applications of piezoelectric transformers, as described for example in the following description of an example of the invention, require the transformer to operate over a large range of conditions whilst at the same time it is desirable that the transformer drive circuit is simple and thus inexpensive.

According to one aspect of the present invention, there is provided circuit for causing a piezo-electric transformer to resonate over a predetermined range of operating conditions over which it has a range of resonant frequencies, the circuit comprising drive means arranged to produce, independently of the transformer, a signal having frequencies spanning the said frequency range for application to the transformer to cause the transformer to resonate over the whole range of operating conditions.

The drive means may be arranged to provide to the transformer all frequencies, or a set of many discrete frequencies, spanning the whole range of operating conditions without feedback from the transformer ensuring resonance under any of the operating conditions.

In an embodiment of the said one aspect, the said range of operating conditions includes a range of operating temperatures and the drive means further comprises an input for receiving a temperature signal representing the operating temperature, the said drive means being responsive to the temperature signal to vary the frequency of the said signal.

In a preferred embodiment, the drive means sequentially, and preferably repetitively, produces all the said frequencies. The preferred embodiment may comprise a controlled oscillator, and a signal generator arranged to produce a control signal for defining the frequency of the oscillator, which control signal sweeps the frequency of the oscillator across the said range of resonant frequencies. The drive means produces a range of frequencies all of amplitude sufficient to maintain the piezo-electric body in resonance over the desired operating range.

The preferred drive circuit for a piezoelectric transformer according to the invention thus avoids the use of feedback from the piezo-electric body to the oscillator simplifying the design of the circuit. Also use of simple temperature feedback to the oscillator increases the reliability of tracking of variations of resonance with temperature. Where the frequency of the oscillator is swept, use of temperature feedback allows a reduction in the sweep range, making the circuit easier to design.

According to another aspect of the present invention, there is provided a circuit for causing a piezo-electric transformer to resonate over a predetermined range of operating temperatures over which it has a range of resonant frequencies, the circuit comprising an input for receiving a temperature signal representing operating temperature and drive means responsive to the temperature signal for producing, independently of the transformer, a signal having a frequency dependent on operating temperature and for applying the said signal to the transformer.

The invention also provides: a combination of a drive circuit according to the invention and a piezoelectric transformer: a gas ignition circuit comprising such a combination; and a gas burning apparatus having such an ignition circuit.

The invention also provides a gas ignition circuit comprising a piezo-electric transformer.

For a better understanding of the present invention, reference will now be made by way of example to the accompanying drawings in which:

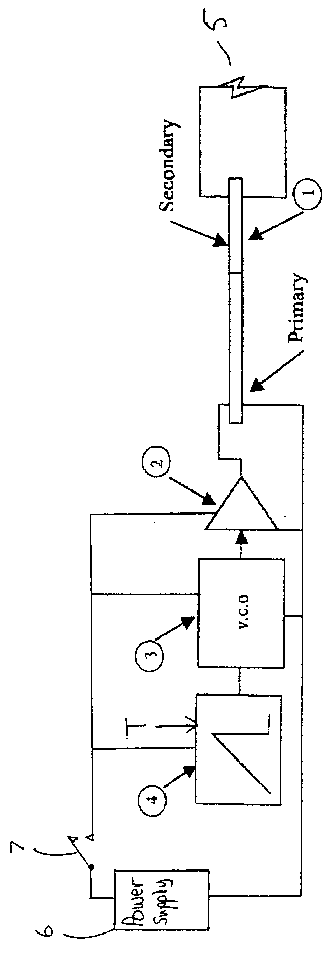

Figure 1 is a schematic block diagram of a piezoelectric transformer and a drive circuit for the transformer.

The transformer 1 and the drive circuit 2 to 4 shown by way of example in Figure 1 is for use in a gas cooker for operating a gas ignitor. The ignitor comprises a spark gap 5 across which an electrical spark is created by the transformer and circuit 2 to 4 to ignite gas. The transformer and circuit 1 to 4 is subject to a harsh operating environment in a gas cooker being subject to an operating temperature range of ambient, e.g. room, temperature to about 160°C. The transformer and circuit 1 to 4 comprises a piezoelectric transformer 1 the resonant frequency of which is sensitive to temperature variations, but the ignitor must operate reliably to ignite gas over the whole operating temperature range. Furthermore, the mechanical mounting of the transformer may be less than ideal.

When it is desired to produce a spark, a power supply 6 is connected to the drive circuit 2 to 4 via a switch 6. The drive circuit 2 to 4 then applies an AC drive signal to the transformer 1. The drive circuit comprises an amplifier 2, a Voltage Controlled Oscillator VCO 3 and a voltage sweep generator 4. The sweep generator 4 repetitively generates a swept waveform in the form of for example a sawtooth as shown. Alternatively the waveform is a staircase waveform. The swept waveform in this example has a repetition period of about 1 second because EMC regulations require a spark repetition rate of greater than 1 second. The swept waveform is applied to the VCO 3 which thus sequentially generates a range of output frequencies defined by the swept waveform. The amplifier 2 simply amplifies the output of the VCO to an amplitude suitable to operate the transformer 1. The amplifier and the VCO together produce a range of frequencies all of which have sufficient amplitude to make the transformer resonate The transformer resonates (and thus the circuit produces sparks) only for the short time the VCO output moves through the appropriate resonant frequency. The sawtooth waveform produces a continuum of frequencies whereas the staircase waveform produces a set of discrete frequencies. The sweep generator is thus preset to produce all the frequencies necessary to cause resonance.

The sweep range of the generator 4 and thus the range of frequencies produced by the oscillator is determined by first determining the range of resonant frequencies of the piezoelectric transformer 1 over the entire desired operating temperature range preferably also taking into account expected variations in the mechanical mounting. Thus the VCO 3 produces a range of frequencies which is guaranteed to result in resonance of the transformer 1 within the range of operating conditions without the use of feedback from the transformer to the VCO 3. The range of frequencies produced by the drive circuit spans the range of resonant frequencies expected in the operating conditions of the transformer, without requiring feedback from the transformer.

In a modification of the circuit shown in Figure 1 a signal T representing operating temperature is applied to the generator 4. The temperature signal applies a DC offset to the sweep produced by the generator 4. This allows the sweep range of the sweep generator to be more reduced (compared to the absence of temperature feedback).

Whilst the invention has been described by way of example to a gas cooker, it may be applied to any gas burning apparatus such as a boiler or gas fired heater. The term gas as used herein includes gas or vapour produced from a flammable liquid such as LPG or petrol.

## Claims

1. A circuit for causing a piezo-electric transformer to resonate over a predetermined range of operating conditions over which it has a range of resonant frequencies, the circuit comprising drive means arranged to produce, independently of the transformer, a signal having frequencies spanning the said frequency range for application to the transformer to cause the transformer to resonate over the whole range of operating conditions.

2. A circuit according to claim 1, wherein the drive means is arranged to produce all the said frequencies sequentially.

3. A circuit according to claim 2, wherein the drive means produces the sequence of frequencies repetitively.

4. A circuit according to claim 1, 2, or 3, wherein the drive means comprises a controlled oscillator, and a signal generator arranged to produce a control signal for defining the frequency of the oscillator, which control signal sweeps the frequency of the oscillator across the said range of resonant frequencies.

5. A circuit according to claim 1, 2, 3 or 4, wherein the said range of operating conditions includes a range of operating temperatures and further comprising an input for receiving a temperature signal representing the operating temperature, the said drive means being responsive to the temperature signal to vary the frequency of the said signal.

6. A circuit according to claim 4, wherein the said range of operating conditions includes a range of operating temperatures and further comprising an input for receiving a temperature signal representing the operating temperature, the temperature signal offsetting the range of the sweep.

7. A circuit according to claim 4, 5, or 6, further comprising an amplifier for amplifying the output signal of the controlled oscillator for application to the transformer.

8. A circuit for causing a piezo-electric transformer to resonate over a predetermined range of operating temperatures over which it has a range of resonant frequencies, the circuit comprising an input for receiving a temperature signal representing operating temperature and drive means responsive to the temperature signal for producing, independently of the transformer, a signal having a frequency dependent on operating temperature and for applying the said signal to the transformer.

9. A circuit for causing a piezo-electric transformer to resonate over a predetermined range of operating conditions and substantially as herein before described with reference to the accompanying drawings.

10. A spark ignition circuit comprising a combination of a circuit according to any preceding claim and a piezoelectric transformer.
